# EUROPEAN PATENT SPECIFICATION

(11) **EP 0 833 385 B1**
(45) Date of publication and mention of the grant of the patent: **11.07.2007**
(21) Application number: 97307526.0
(22) Date of filing: 25.09.1997
(51) Int. Cl.: H01L 27/146, H01L 31/036

(54) **Method of producing a sensor device**
Verfahren zur Herstellung einer Sensoranordnung
Procédé de fabrication d'un dispositif capteur

(30) Priority: 27.09.1996 US 714934; 27.09.1996 US 721813
(43) Date of publication of application: 01.04.1998
(73) Proprietor: Xerox Corporation, Rochester, New York 14644 (US)
(72) Inventor: Tsai, Chuang-Chuang, San Jose, CA 95129 (US); Yao, William W., Los Altos, CA 94024 (US); Fulks, Ronald T., Mountain View, CA 94040 (US)
(74) Representative: Grünecker, Kinkeldey, Stockmair & Schwanhäusser Anwaltssozietät

(56) References cited:
- US-A- 4 571 348
- US-A- 4 842 892
- US-A- 5 262 649
- PARK B W ET AL: "Microcrystalline silicon in image sensor" MICROCRYSTALLINE SEMICONDUCTORS: MATERIALS SCIENCE AND DEVICES SYMPOSIUM, BOSTON, MA, USA, 30 NOV.-4 DEC. 1992, pages 609-614, XP002086804 1993, Pittsburgh, PA, USA, Mater. Res. Soc, USA
- LUSTIG N ET AL: "GATE DIELECTRIC AND CONTACT EFFECT IN HYDROGENATED AMORPHOUS SILICON-SILICON NITRIDE THIN-FILM TRANSISTORS" JOURNAL OF APPLIED PHYSICS, vol. 65, no. 10, 15 May 1989, pages 3951-3957, XP000615789
- KANICKI J ET AL: "PROPERTIES OF HIGH CONDUCTIVITY PHOSPHOROUS DOPED HYDROGENATED MICROCRYSTALLINE SILICON AND APPLICATION IN THIN FILM TRANSISTOR TECHNOLOGY" MATERIALS RESEARCH SOCIETY SYMPOSIUM PROCEEDINGS, vol. 149, 25 April 1989, pages 239-246, XP000614731

## Description

The present invention relates to sensor devices and their production.

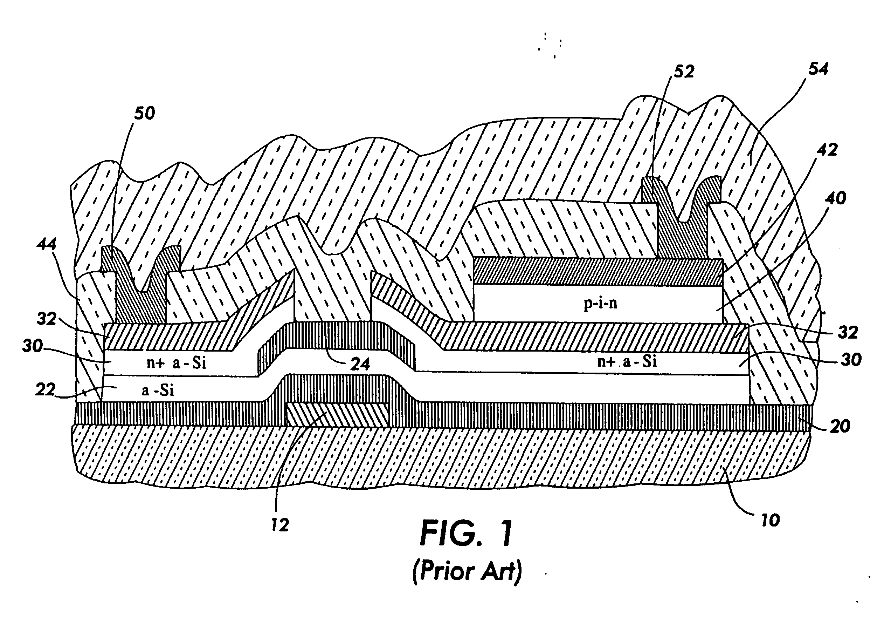

Fig. 1 shows an example of a prior art sensor array, formed at a surface of glass substrate 10. Gate 12 conventionally includes highly conductive metal and is connected to a scan line for receiving signals that control conductivity of a thin film transistor (TFT).

Insulating layer 20, conventionally silicon nitride (SiN), separates gate 12 from intrinsic semiconductor layer 22, the layer in which the TFTs channel is formed. Semiconductor layer 22 is conventionally amorphous silicon (a-Si), and it is covered in the channel region by insulating island 24, conventionally formed in another layer of SiN. The channel therefore extends from a connecting region at one side of island 24 to another connecting region at the other side of island 24.

Doped semiconductor layer 30 and conductive metal layer 32 are patterned to form channel leads for the TFT, and an opening is therefore formed over island 24 so that the channel leads are isolated. Doped semiconductor layer 30 includes one semiconductor lead in electrical contact with the connecting region at one side of island 24 and another semiconductor lead in electrical contact with the connecting region at the other side of island 24. For process compatibility, doped semiconductor layer 30 is conventionally heavily n-doped (n+) a-Si, while conductive metal layer 32 can be sputtered chromium.

Silicon-based sensor layer 40 is formed over metal layer 32 and acts as a diode. Sensor layer 40 can be formed in a conventional p-i-n layer or a Schottky diode layer, deposited in either case by plasma-enhanced chemical vapor deposition (PECVD), conventionally performed at temperatures greater than 180°C, typically between 200-350°C.

Over sensor layer 40, Fig. 1 also shows electrode layer 42, conventionally a layer of indium-tin-oxide (ITO), and lower passivation layer 44, conventionally a layer of silicon-based dielectric. Layer 44 is patterned to form openings to metal layer 32 on one side of the TFT and to ITO layer 42 on the other side. Then another conductive metal layer is deposited and patterned to provide data line 50 and bias line 52, connected respectively to metal layer 32 and ITO layer 42 through the openings. Finally upper passivation layer 46 covers the array, and is conventionally another layer of silicon-based dielectric.

Kanicki, J., Hasan, E., Griffith, J., Takamori, T., and Tsang, J.C., "Properties of High Conductivity Phosphorous Doped Hydrogenated Microcrystalline Silicon and Application in Thin Film Transistor Technology," Mat. Res. Soc. Symp. Proc., Vol. 149, 1989, pp. 239-246, disclose use of a heavily (n+) P-doped microcrystalline silicon (µc-Si:H) layer in a hydrogenated amorphous silicon (a-Si:H) thin film transistor (TFT) as a contact interlayer between a source/drain metal and a-Si:H layer. Kanicki et al. disclose application in sensing elements for integrated sensors.

US-A-5,473,168 discloses a thin film transistor with contact layers of n-type microcrystalline silicon.

US-A-5,262,649 discloses a detector array with columns and rows of amorphous silicon photodiodes, each connected to a thin film transistor. The thin film transistors may be formed with an a-Si:H layer or with polycrystalline silicon.

PARK B W ET AL: "Microcrystalline silicon in image sensor" MICROCRYSTALLINE SEMICONDUCTORS: MATERIALS SCIENCE AND DEVICES SYMPOSIUM, BOSTON, USA, 30 NOV.-4 DEC. 1992, pages 609-614, Mater. Res. Soc, USA. A linear image sensor driven by thin film transistor as an switching element, with each photodiode connected to the corresponding thin film transistor has been investigated. The photo/dark conductivity of photodiode are compared in the case of amorphous silicon and microcrystalline. The influence in contact resistance between microcrystalline n⁺ layer and the source/drain metal electrode, electron mobility, threshold voltage, and on-off current ratio of thin film transistor with intrinsic microcrystalline silicon layer were also investigated.

US 4,571,348 describes reducing hydrogen content of vacuum deposited films. A method of treating thin films containing a significant atomic proportion of hydrogen to enable such films to be subjected to elevated temperatures without blistering. The films are subjected to a significant, i.e. damaging, high implantation prior to heat treatment.

US 4,842,892 describes method for depositing an n+ amorphous silicon layer onto contaminated substrates. A method of depositing a delamination bubble-free PECVD thin film n+ amorphous silicon layer, from the decomposition of a gaseous mixture of silane and phosphine, upon a substrate having one or more thin film layers thereon, wherein there is contamination upon the exposed surface of the outer thin film layer

KANICKI J ET AL: "PROPERTIES OF HIGH CONDUCTIVITY PHOSPHOROUS DOPED HYDROGENATED MICROCRYSTALLINE SILICON AND APPLICATION IN THIN FILM TRANSISTOR TECHNOLOGY" MATERIALS REASEARCH SOCIETY SYMPOSIUM PROCEEDINGS, vol. 149, 25 April 1989, pages 239-246. Thin film transistors incorporating heavily P-doped amorphous and microcrystalline layer between source/drain metal and the a-Si:H channel have been fabricated. It is shown that an n⁺ µc - Si:H source/drain contacts in thin film transistors provides very good characteristics, yielding an average effective field effect mobility, threshold voltage, and on/off current ratio of about 0.9cm²V⁻¹sec⁻¹, below 4 V, and above 10⁷, respectively.

It is the object of the present invention to improve production of a sensor device including a sensing element and a thin film transistor particularly with regard to avoiding bubble formation with doped semiconductor channel leads. This object is achieved by providing a method for producing a sensor device according to claim 1.

Embodiments of the invention are set forth in the dependent claims.

The invention addresses a problem that arises in producing structures like that described above in relation to Fig. 1. The thermal cycle of PECVD deposition of silicon-based sensor layer 40 includes temperatures comparable to those at which previous silicon-based layers were deposited, causing gas to migrate out of the previous layers. The gas may form bubbles between layers. For example, bubbles may form at the sides of doped semiconductor layer 30 because heat causes hydrogen from layer 30 to travel to interfaces with other layers where the hydrogen becomes trapped. Such bubbles cause defects in the resulting structure, such as film peeling, or delamination, and particle generation which lead to a degradation in yield and reliability.

The invention alleviates the bubble formation problem with doped semiconductor channel leads formed in a layer of microcrystalline silicon (µc-Si). This alleviates the problem because semiconductor channel leads in the µc-Si layer can have a structure that prevents bubble formation during the subsequent production of a sensing element in another silicon-based layer.

The invention will now be described, by way of example, with reference to the accompanying drawings, in which:
Fig. 1 is a cross section showing a prior art sensor device;
Fig. 2 is a flow chart showing general acts in a method that produces a semiconductor layer with µc-Si;
Fig. 3 is a schematic diagram showing relationships between hydrogen pressure and the pressure at which bubbles form across a silicon-based layer;
Fig. 4 is a graph showing ranges of atomic percentage of hydrogen in different silicon-based materials;
Fig. 5 is a graph showing ranges of pressure gradients in different silicon-based materials;
Fig. 6 is a graph showing interface stability for different interfaces between µc-Si and other materials;
Fig. 7 is a schematic diagram showing a sensor array and a layout of a cell's circuitry in the array;
Fig. 8 is a cross-section of a TFT in the cell circuitry of Fig. 7, taken along line 8-8 in Fig. 7;
Fig. 9 is a flow chart showing acts in producing the array of Fig. 7;
Fig. 10 is a cross-section of an alternative TFT that could be used in the cell circuitry of Fig; and
Fig. 11 is a flow chart showing acts in producing an array with TFTs as in Fig. 10.

A "substrate" or "chip" is a unit of material that has a surface at which circuitry can be formed or mounted.

A "layer" is a thickness of material formed over a surface and extending generally parallel to the surface, with one side toward the surface and another side away from the surface. A layer may include two or more layers within it, referred to as "sublayers." A layer may be homogeneous or its composition may vary.

To perform "physical vapor deposition" is to cause a material to be deposited on a physical structure without a chemical reaction. Examples include sputtering, vacuum evaporation, and e-beam deposition.

To perform "chemical vapor deposition" is to cause a material to be deposited on a physical structure by use of reactant gases and an energy source to produce a gas-phase chemical reaction. The energy source could be thermal, optical, or plasma in nature; "plasma enhanced chemical vapor deposition° or "PECVD" uses a plasma energy source. A "PECVD layer" is a layer produced by PECVD.

A "patterned layer" is a layer that forms a pattern. For example, a patterned layer may be formed by removing part of a layer to form a pattern or by depositing a layer in a pattern. To perform "lithography" or to "lithographically pattern" is to use a radiation source to transfer a mask pattern to a layer of radiation-sensitive material and then to develop the radiation-sensitive material to obtain a positive or negative copy of the mask pattern. The radiation-sensitive material is referred to as "resist" or "photoresist." If it is to be used for etching, a pattern of resist that results from development may be referred to as a "pattern of mask material" or simply a "mask."

A "lithographically patterned layer" is a layer in which a pattern has been formed by performing lithography to produce a pattern of mask material and by then etching away either the part of the layer that is not covered by the pattern or the part that is covered.

A process "implants" a dopant into a part of a layer if the process causes particles of the dopant to enter the part of the layer. Implanting therefore includes both conventional ion implantation and also "ion shower" doping.

In a structure at a surface, a part of a first layer "covers" or "is over" a part of a second layer if the part of the second layer is between the part of the first layer and the surface. A part of a first layer is "formed on" a part of a second layer if the part of the first layer has a lower side that meets the upper side of the part of the second layer at an interface between the first and second layers.

A layer or part of a layer is "doped" if it contains dopant and "undoped" or "intrinsic" if it does not.

An operation "deposits a doped layer" if the operation deposits the layer so that it contains dopant when deposited. Such a layer may be referred to as a "deposited doped layer" to contrast it with a layer that is doped after deposition.

A "lead" is a part of a component at which the component is electrically connected to other components. A "line" is a simple component that extends between and electrically connects two or more leads. A line is "connected between" the components or leads it electrically connects. A lead of a component is "connected" to a lead of another component when the two leads are electrically connected by a combination of leads and lines. In an integrated circuit, leads of two components may also be "connected" by being formed as a single lead that is part of both components.

In a thin film structure, the terms "gate region," "gated region," and "channel" have related meanings: A "gate region," sometimes called a "gate," is a part of a layer that controls conductivity of a "gated region" that is part of another layer, typically defined by the projection of the gate region onto the other layer; conversely, a "gated region" is a part of a layer with conductivity that changes depending on the gate region; a "channel" is formed when current flows through a gated region. A channel is "highly conductive" or "ON" when the channel is in a state in which current can flow freely through it. A channel is "OFF" when the channel is in a state in which very little current can flow through it.

A "transistor" is a component that has a channel or a series of channels that extends between two channel leads, and that also has a third lead-referred to as a "gate lead" or simply "gate"-such that the channel or series of channels can be switched between ON and OFF by signals that change potential difference between the gate and one of the channel leads, referred to as the "source." The channel lead that is not the source is referred to as the "drain." Other components may have leads called gates, sources, and drains by analogy to transistors. Other components may have leads called gates, sources, and drains by analogy to transistors.

A "crystalline grain structure", or simply "grain structure", in a material is a crystalline part of the material. A "grain size" is a size of a crystalline grain structure or a size representative of a collection of crystalline grain structures.

As used herein, "microcrystalline silicon" or "µc-Si" means silicon formed with crystalline grain structures that have grain sizes greater than 20Å (2nm). µc-Si can be distinguished from amorphous silicon (a-Si) based on presence of crystalline grain structures-true amorphous silicon does not include crystalline grain structures. Crystalline grain structures can be observed, for example, by Raman scattering, by transmission electron microscopy (TEM), by scanning electron microscopy (SEM), or by x-ray diffraction. Doped µc-Si can also be distinguished from doped a-Si by electrical measurements such as sheet resistivity-doped a-Si has higher resistivity. In contrast with conventional polycrystalline silicon (poly-Si), both µc-Si and a-Si are typically produced by low temperature processes in which substrate temperatures do not exceed 350°C, such as PECVD, including remote plasma PECVD, sputtering, and evaporation with an unheated or lightly heated substrate. Various parameters can be adjusted to determine whether a-Si or µc-Si is produced, including ratio of H₂, gas pressure, rf power, and so forth. In contrast with µc-Si and a-Si, poly-Si has sharp grain boundaries and is substantially hydrogen free. Poly-Si is typically produced by low pressure CVD (LPCVD), by high temperature PECVD, or by post annealing of a-Si. µc-Si therefore includes more hydrogen than poly-Si and has a larger distribution of grain sizes.

A "silicon-based material" is a material in which silicon is a major component. Examples include crystalline silicon, a-Si, µc-Si, poly-Si, silicon nitride, silicon carbide, silicon-germanium alloys, and so forth.

A "channel lead" is a lead that connects to a channel. A channel may, for example, extend between two "connecting regions" that are electrically connected to two channel leads.

A part of a layer is "in electrical contact with" a part of another layer if the two parts meet in such a way that they are electrically connected. For example, a semiconductor channel lead can be in electrical contact with a connecting region at an end of a semiconductor channel if the semiconductor channel lead is either immediately over or under the connecting region in another layer or is immediately adjacent the connecting region in the same layer. Similarly, a metal channel lead can be in electrical contact with a semiconductor channel lead if the metal channel lead is either immediately over or under the semiconductor channel lead in another layer.

A part of a layer has "a structure that prevents formation of bubbles" at a side of the layer during an operation if the part's structure has a structural characteristic that prevents formation of bubbles. For example, if the operation is a high temperature operation such as production of a sensing element in a silicon-based layer, the structure can prevent formation of bubbles by reducing the production of gas, by permitting dissipation of gas, or by strengthening the structure so that gas cannot cause bubbles. If the part of the layer is a semiconductor channel lead formed in a silicon-based layer, for example, the structure can include sufficiently small amount of hydrogen to prevent formation of bubbles; can include grain structures that permit hydrogen to dissipate at a sufficient rate to prevent formation of bubbles; or can have interfaces sufficiently stable to prevent formation of bubbles.

A "sensing element" is a component that can receive a stimulus and can provide an electric signal indicating a measure of the received stimulus. The received stimulus could be electromagnetic radiation, pressure, temperature, chemicals, or any other stimulus that can be sensed and measured.

Similarly, a "sensor device" is a device that can receive information in a form other than electric signals and can provide an electric signal indicating the received information.

The terms "array" and "cell" are related: An "array" is an article of manufacture that includes an arrangement of "cells." For example, a "two-dimensional array" or "2D array" includes an arrangement of cells in two dimensions. A 2D array of circuitry may include rows and columns, with a line for each row and a line for each column. Lines in one direction may be "data lines" through which a cell receives or provides signals, referred to as "data signals," that determine or indicate its state. Lines in the other direction may be "scan lines" through which a cell receives a signal, referred to as a "scan signal," enabling it to receive signals from or provide signals to its data line.

A "sensor array" is a sensor device that receives information in the form of an image or pattern detected by an array of sensing elements.

In an alloy or other mixture of two or more elements, the relationship between the quantities of atoms of the elements can be expressed as an "atomic percent," an "atomic proportion," or an "atomic ratio."

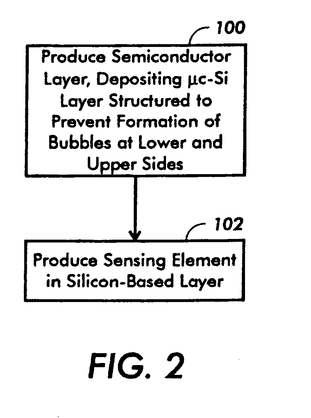

The act in box 100 in Fig. 2 produces a semiconductor layer. In doing so, the act in box 100 deposits a µc-Si layer, and the µc-Si layer is structured to prevent formation of bubbles at the lower and upper sides of the semiconductor layer during subsequent production of a sensing element in a silicon-based layer.

The act in box 102 then produces a sensing element in a silicon-based layer over the semiconductor layer. Because of the structure of the µc-Si layer, the act in box 102 does not result in bubble formation at the lower and upper sides of the semiconductor layer.

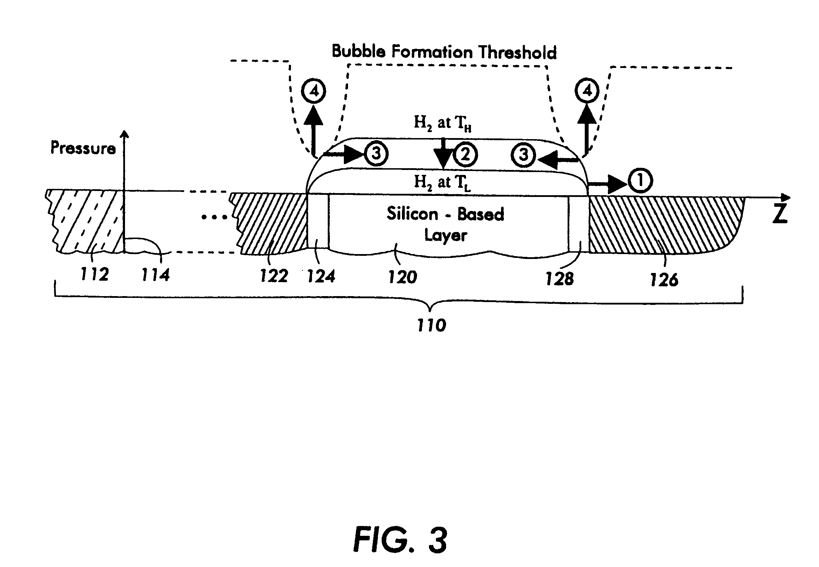

The lower part of Fig. 3 shows a partial cross-section of structure 110, including substrate 112 with surface 114 on which layers have been formed and with distance in the z-dimension being measured upward from surface 114. Silicon-based layer 120 is over layer 122, with layers 120 and 122 meeting at interface 124. Similarly, layer 126 is over silicon-based layer 120, with layers 120 and 126 meeting at interface 128.

The upper part of Fig. 3 shows a graphical relationship between three measurements of gas pressure that vary in the z-dimension. The dashed curve at the top shows the gas pressure threshold above which bubbles form. Because each of layers 120, 122, and 126 has a high degree of structural stability, the bubble formation threshold within each layer is very high. But structure at interfaces 124 and 128 is not as stable, so that the bubble formation threshold dips--a relatively low gas pressure can cause a bubble to form at one of the interfaces.

The two solid curves show the pressure of hydrogen gas (H₂) at two temperatures, a lower temperature (T_{L}) and a higher temperature (T_{H}). As can be seen, the H₂ pressure at T_{L} stays well below the bubble formation threshold, so that bubbles are very unlikely to form if the subsequent processing of structure 110 does not involve temperatures greater than T_{L}. But if subsequent processing requires temperatures as high as T_{H}, which could be a temperature that occurs in producing a sensing element in another silicon-based layer, H₂ pressure rises and it becomes likely that bubbles will form at one or both of the interfaces.

The arrows in the upper part of Fig. 3 suggest four specific approaches to preventing bubble formation. The first approach, illustrated by the arrow with the number "1" in a circle, modifies the structure of layer 126 so that H₂ from layer 120 can enter layer 126, reducing pressure at interface 128. An example of the first approach can be understood in relation to Fig. 1, in which layer 32 could be formed of a material that would permit hydrogen to dissipate at a rate that would prevent bubble formation. In contrast to the first approach, the other three approaches all involve changes in the structure of layer 120.

The second approach, illustrated by the arrow with the number "2" in a circle, provides layer 120 with a lower atomic percentage of H, so that less H₂ is generated at T_{H}. If the atomic percentage of H is sufficiently low, the T_{H} curve of H₂ pressure does not reach the bubble formation threshold, and bubbles are unlikely to form at either of the interfaces.

The third approach, illustrated by the arrows with the number "3" in a circle, provides layer 120 with a structure that permits hydrogen to dissipate, so that the slope of the T_{H} curve of H₂ pressure is less steep across interfaces 124 and 128. If the slope is sufficiently low, the T_{H} curve again does not reach the bubble formation threshold, and bubbles are unlikely to form at either of the interfaces.

The fourth approach, illustrated by the arrows with the number "4" in a circle, provides layer 120 with a structure that provides more stability at interfaces 124 and 128. As a result, the bubble formation threshold rises at each of interfaces 124 and 128. If the interfaces are sufficiently stable that the T_{H} curve does not reach the bubble formation threshold, bubbles are unlikely to form at either of the interfaces.

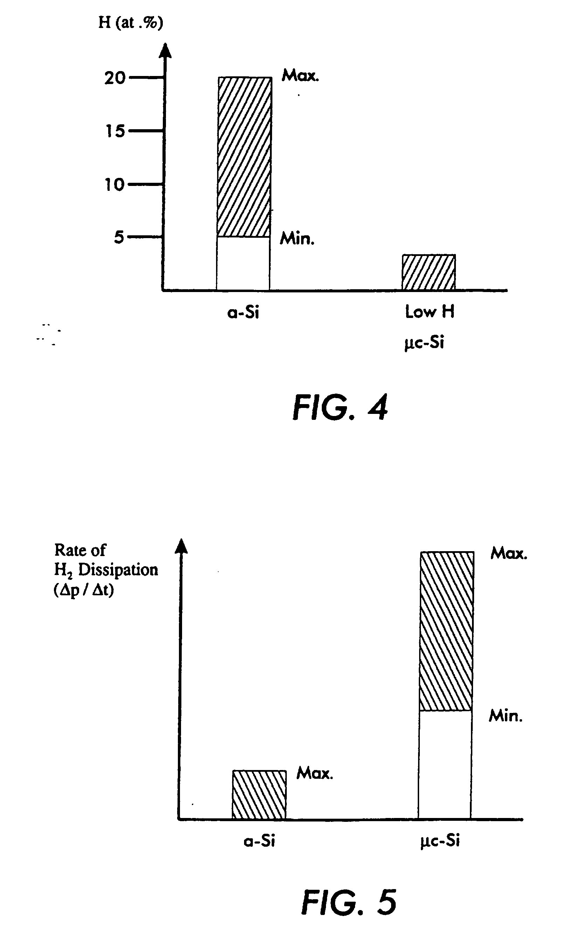

Figs. 4, 5, and 6 illustrate respectively how the second, third, and fourth approaches can be followed if silicon-based layer 120 is a layer of µc-Si.

In the bar graph of Fig. 4, the vertical axis indicates atomic percentage of H. As shown, typical a-Si materials include between 5 and 20 atomic percent of H, while useful µc-Si material may have less than 5 atomic percent of H and typically has 1-3 atomic percent of H or less. Therefore, changing from a layer of a-Si to a layer of low H µc-Si can significantly reduce the atomic percentage of H. Because bubble formation correlates directly with the atomic percentage of H in a silicon-based material, reducing atomic percentage of H can prevent bubble formation.

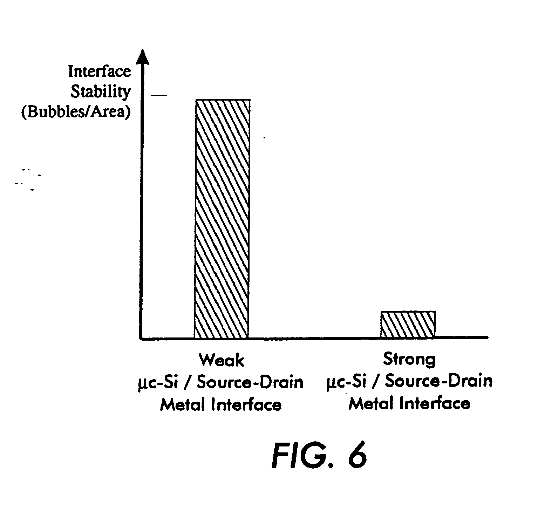

In the bar graph of Fig. 5, the vertical axis indicates the rate of H₂ dissipation, which could be measured as Δp/Δt, where Δp is an incremental difference in pressure and Δt is an incremental time. As shown, the maximum rate of H₂ dissipation that can occur in typical a-Si materials is believed to be lower than the minimum that can occur in µc-Si materials, as a result of crystalline grain structures in µc-Si. The crystalline grain structures are relatively dense and are surrounded by less dense material. Although H₂ movement is inhibited within the dense material of the grain structures, the grain boundaries and the less dense material are believed to have higher mobility for hydrogen, permitting hydrogen to dissipate.

Across the spectrum of crystalline grain structure size varying from very small in some µc-Si to very large in single crystal silicon, the rate of H₂ dissipation is believed to increase as crystalline grain structures increase in size from a-Si to µc-Si, reaching maximum at microstructure sizes characteristic of some µc-Si or poly-Si, and then decreasing again before the size approaches that of single crystal silicon. The rate of H₂ dissipation is also believed to vary with crystalline grain structure shape, with columnar structures permitting faster dissipation than spherical shapes. Therefore, if the crystalline grain structures in µc-Si have appropriate sizes and shapes, H₂ dissipates rapidly, making it less likely that the bubble formation threshold will be reached.

In the bar graph of Fig. 6, the vertical axis indicates interface stability, which could be measured in bubbles per unit of area. As shown, a weak interface between µc-Si and source-drain metal results in significantly more bubbles per unit of area than a strong interface between the same materials. A weak interface can be produced, for example, by the presence of oxide or other substances on a µc-Si surface before source-drain metal is deposited over it or by waiting for an extended period of time, such as a few days, to deposit source-drain metal on a µc-Si surface, permitting oxide to form. Therefore, if the µc-Si/source-drain metal interface is structured with sufficient stability, the bubble formation threshold at the interface increases, making it less likely that the bubble formation threshold will be reached.

The implementations described below provide active matrix sensor arrays with TFTs as switching elements.

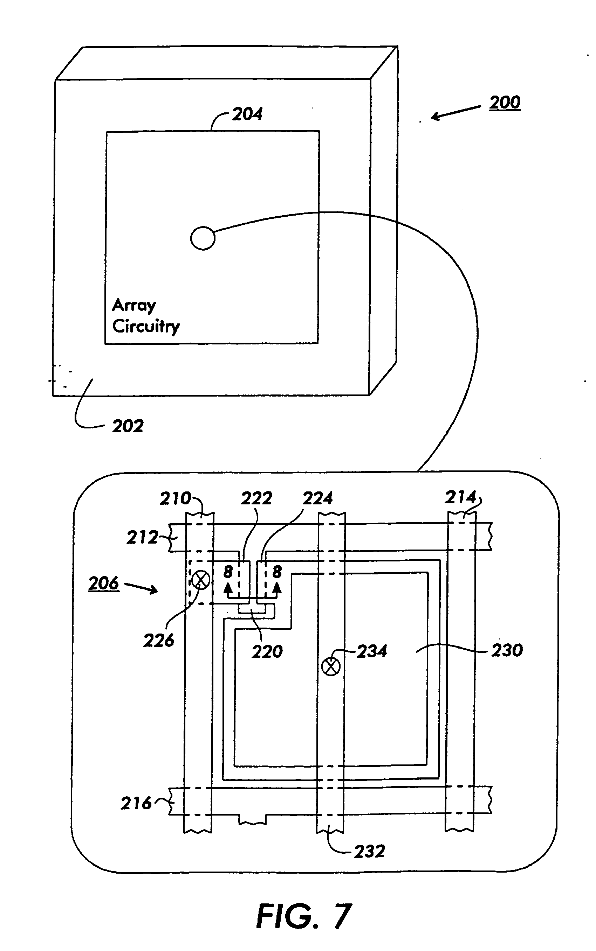

Fig. 7 shows a sensor array in which channel leads are formed in microcrystalline silicon to prevent bubble formation.

Array 200 in Fig. 7 includes glass substrate 202 at a surface of which array circuitry 204 is formed. Array circuitry 204 includes cells, with representative cell 206 being shown in more detail.

Cell 206 includes cell circuitry that provides signals on data line 210 in response to scan signals on scan line 212. The components that form the cell circuitry are also bounded by data line 214 and scan line 216.

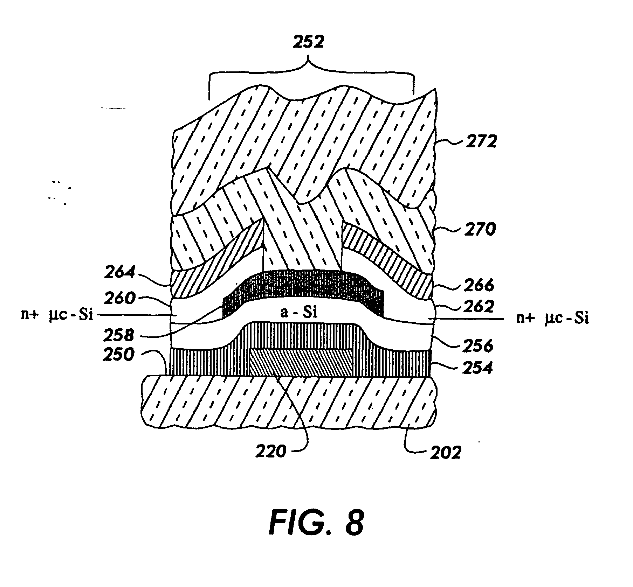

Gate 220, formed in the same layer as scan lines 212 and 216 and electrically connected to scan line 212, extends under a channel of an a-Si TFT, as explained below in relation to Fig. 8. Over gate 220, channel leads 222 and 224 are formed, each with an n+ µc-Si semiconductor lead and a conductive metal lead. As shown, channel lead 222 has electrical connection 226 to data line 210, which can be formed through an opening in an insulating layer between channel lead 222 and data line 210.

The layers that form channel lead 224 can cover nearly all the area bounded by data lines 210 and 214 and scan lines 212 and 216. Over channel lead 224 is sensing element 230, with a diode formed in a semiconductor layer and with an electrode formed in a conductive metal layer. Bias line 232, formed in the same layer as data lines 210 and 214, has electrical connection 234 to the electrode of sensing element 230.

The cross section in Fig. 8 shows glass substrate 202 with surface 250 at which TFT 252 is formed. Gate 220 is formed on surface 250, and is electrically connected to scan line 212 as shown in Fig. 7.

Insulating layer 254, a layer of SiN, separates gate 220 from intrinsic semiconductor layer 256, the layer of a-Si in which the channel of TFT 252 is formed. Semiconductor layer 256 is covered in the channel region by insulating island 258, another layer of SiN.

Semiconductor leads 260 and 262 are formed in a layer of n+ µc-Si, and are in electrical contact with the connecting regions of the channel at either side of island 258. Metal leads 264 and 266 are formed in a layer of chromium or another conductive metal. Together, semiconductor lead 260 and metal lead 264 form one channel lead of TFT 252, while semiconductor lead 262 and metal lead 266 form the other channel lead.

Fig. 8 also shows lower passivation layer 270 and upper passivation layer 272, each a layer of silicon oxynitride.

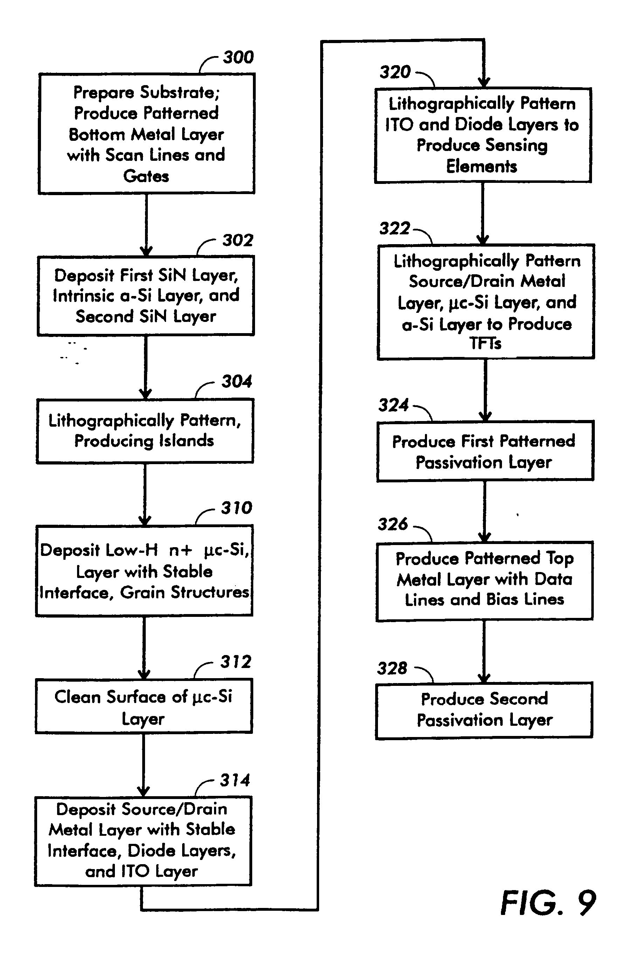

The acts in Fig. 9 fabricate an array with a layer of doped µc-Si as in Fig. 8 and are similar to those described in relation to Fig. 6 of US-A-5,648,674.

The act in box 300 in Fig. 9 can begin by preparing surface 250 of substrate 202, which can be a glass substrate such as Corning 7059 glass. The act in box 300 can include any necessary cleaning. The act in box 300 then produces the first patterned conductive layer, with scan lines 212 and 216 and gate 220. For example, as described in US-A-5,648,674, the act in box 300 can produce aluminum shunts 8 µm wide and 800 Å (80 nm) thick; then the act in box 300 can sputter deposit an alloy of titanium tungsten to a thickness of about 1200 Å (120nm), then use photolithographic techniques to produce a mask and etch to obtain scan lines approximately 14 µm wide and other features as in Fig. 7.

The act in box 300 could alternatively use other techniques. For example, the first conductive layer could include sputter deposited MoCr, or a multilayered structure of alternating layers of Al and TiW, or Al with a dual dielectric capping layer, including low temperature deposited SiON and high temperature plasma enhanced chemical vapor deposited (PECVD) SiN. These techniques are discussed in greater detail in EP-A1-0 680 088, in US-A-5,518,805, and in EP-A2-0 681 327.

The act in box 302 then produces insulating layer 254, intrinsic semiconductor layer 256, and the insulating layer that includes island 258 by a sequence of PECVD steps. Insulating layer 254 can be silicon nitride deposited at about 300-380 degrees C to a thickness of about 3000 Å (300 nm). Intrinsic semiconductor layer 256 can be a layer of intrinsic a-Si that includes 5-12% hydrogen and is deposited at about 230-300 degrees C to a thickness of about 300-500 Å (30-50 nm); intrinsic semiconductor layer 256 can alternatively be a layer of intrinsic µc-Si deposited as described below in relation to box 310 but without PH₃; or intrinsic semiconductor layer 256 could be an appropriately formed layer of intrinsic poly-Si. The upper insulating layer that includes island 258 can be silicon nitride deposited primarily as an etch stop at 200-250 degrees C to a thickness of about 1000-1500 Å (100-150 nm).

The act in box 304 patterns the upper insulating layer to produce island 258. The act in box 304 can use photolithographic techniques to produce islands by exposing a photoresist layer using a photolithographic mask and by then etching to remove exposed areas of photoresist and then exposed portions of the upper insulating layer. The act in box 304 can also include cleaning, such as conventional cleaning with a wet etch, to remove native oxide so that a stable interface can be formed with a layer of µc-Si. Care should be taken to avoid creation of defects that would weaken the interface.

The act in box 310 deposits a layer of low-H n+ µc-Si over the cleaned surface of layer 256 and island 258. The act in box 310 can deposit µc-Si by first performing plasma enhanced CVD at 0.1-2.0 Torr. (13.3 - 266 Pa) with 2% a mixture of SiH₄ and PH₃, and the other 98% H₂, at a high deposition power and 13.56 megahertz r.f. to deposit a heavily n+ doped µc-Si layer at 200-300° C with 1-3 at. % hydrogen to a thickness of 500-1000 angstroms (50-100 nm). The PH₃-SiH₄ mixture can have 0.5-5.0% PH₃. The µc-Si layer should be thick enough to be sufficiently conductive to function as a channel lead. The proportions of gases should be chosen to obtain an appropriate grain size and an appropriate level of dopant. The µc-Si layer can be doped, for example, with 0.5-5.0% phosphorous. The µc-Si should be developed so that microcrystalline grain structures such as columnar grain structures permit hydrogen to dissipate and prevent bubble formation.

The act in box 312 dips the layer of µc-Si from box 310 in an appropriate solvent, such as dilute HF, to remove oxide. This act helps to ensure that a stable interface can be formed with the next layer. Alternatively, an RF backsputter could be performed to remove oxide. The act in box 312 can also include cutting openings to peripheral pads.

The act in box 314 deposits a series of layers in which sensing elements can be formed. The first layer is the source/drain metal in which metal channel leads 264 and 266 are formed; this can be a sputtered layer of chromium, which forms a stable interface with the µc-Si layer. The next layers are the layers of a diode, and can be a conventional p-i-n layer or Schottky diode layer, deposited in either case by plasma-enhanced chemical vapor deposition (PECVD) at temperatures of 200-250 degrees C. The final layer is a layer of highly conductive, transparent material in which the sensing element's upper electrode is formed; this can be a layer of indium-tin-oxide (ITO), deposited using reactive sputter techniques in 0.5-1.5% O₂ to a thickness of about 500-1000 Å (50-100 nm).

The act in box 320 patterns the ITO and diode layers to produce the sensing element. The act in box 320 can use photolithographic techniques, exposing a photoresist layer using a photolithographic mask and then etching to remove exposed areas of photoresist and then exposed portions of the ITO and diode layers. The act in box 320 can also anneal the ITO layer at a temperature of 200-230 degrees C for approximately one hour. The act in box 320 can also cut openings to the chromium layer over peripheral pads.

The act in box 322 patterns the source/drain metal layer, the µc-Si layer, and the intrinsic a-Si layer to complete transistor 252. The act in box 322 can similarly use photolithographic techniques, exposing a photoresist layer using a photolithographic mask and then etching to remove exposed areas of photoresist and then exposed portions of the source/drain metal layer, the µc-Si layer, and the intrinsic a-Si layer. Island 258 acts as an etch stop, to prevent etching of the channel of TFT 252.

The act in box 324 produces lower passivation layer 270 with openings for electrical connections 226 and 234. The act in box 324 can deposit a passivation material such as silicon oxynitride to a thickness of 6000 Å (600 nm) or thicker if necessary to reduce coupling. The act in box 324 can then use photolithographic techniques to mask and then etch the resulting layer to produce an opening exposing part of metal lead 264 and part of the electrode of sensing element 230 in each unit of cell circuitry.

The act in box 326 produces the patterned top metal layer with data lines 210 and 214 and bias line 232. The act in box 326 can sputter deposit a thin layer of titanium tungsten to a thickness of approximately 500 Å (50 nm), followed by a thicker layer of aluminum to a thickness of 4000-5000 Å (400-500 nm), and capped by a final layer of titanium tungsten to a thickness of approximately 500-1000 Å (50-1000 nm). These three metal layers can be sputter deposited in sequence in a chamber without breaking the vacuum between depositions. The act in box 316 can then use photolithographic techniques to mask and then etch the resulting layer, first etching titanium tungsten with H₂O₂, followed by a standard aluminum etch, and finally etching titanium tungsten again with H₂O₂.

The act in box 328 produces upper passivation layer 272. The act in box 328 can deposit a passivation material such as silicon oxynitride to a thickness of 6000 Å (600 nm) or thicker if necessary to reduce coupling. The act in box 328 can also cut openings to peripheral pads so that connections can be made.

The technique of Fig. 9 can include further conventional acts (not shown) to cut through layer 272 to contact pads, to coat the array with x-ray sensitive material such as selenium and arsenic, and to otherwise complete the manufacturing process.

The implementation described above in relation to Figs. 7-9 has been partially implemented experimentally by producing sensor structures with doped µc-Si layers having 2-3 at. % hydrogen and by also producing TFTs that include such layers. Analysis of the µc-Si layers shows the presence of crystalline grain structures observable using SEM or TEM imaging and the prevention of bubble formation across a wider range of process temperatures than is possible with a-Si layers. TFTs according to the above implementation are operable and sensor structures function to sense visible light.

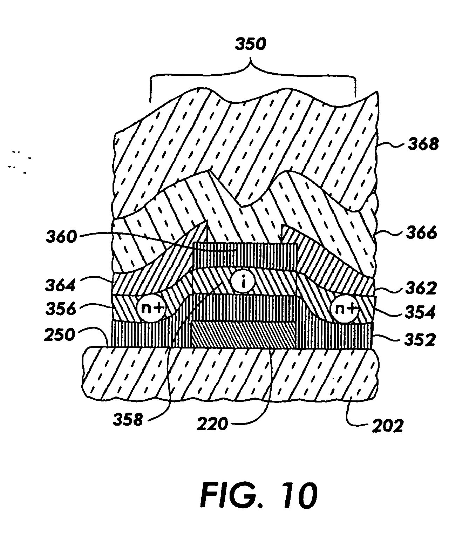

Fig. 10 shows a cross section of the array of Fig. 7 along the line 8-8. illustrating an alternative implementation with a layer of µc-Si that includes a channel as well as doped semiconductor leads.

The cross section in Fig. 10 shows glass substrate 202 with surface 250 at which TFT 350 is formed. As in Fig. 8, gate 220 is formed on surface 250, and is electrically connected to scan line 212 as shown in Fig. 7.

Insulating layer 352, a layer of SiN, separates gate 220 from a µc-Si layer that includes n⁺ semiconductor channel leads 354 and 356 and intrinsic channel 358. Leads 354 and 356 are in electrical contact with connecting regions of channel 358 within the µc-Si layer. The µc-Si layer is covered in the channel region by insulating island 360, formed in another layer of SiN with its edges aligned with the edges of gate 220.

As in Fig. 8, metal leads 362 and 364 are formed in a layer of chromium or another conductive metal. Together, semiconductor lead 354 and metal lead 362 form one channel lead of TFT 350, while semiconductor lead 356 and metal lead 364 form the other channel lead.

Fig. 10 also shows lower passivation layer 366 and upper passivation layer 368, each a layer of silicon oxynitride.

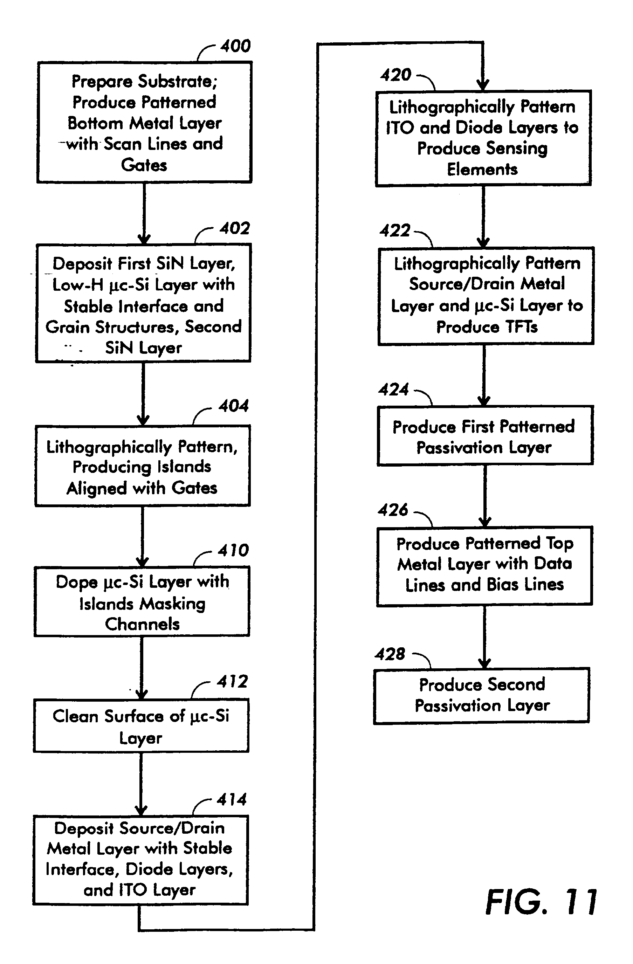

The acts in Fig. 11 are similar to those described above in relation to Fig. 9. The acts in boxes 400, 412, 414, 420, 424, 426, and 428 can be implemented as described above in relation to boxes 300. 312, 314, 320, 324, 326, and 328 in Fig. 9.

The act in box 402 produces insulating layer 352, the µc-Si layer that includes semiconductor leads 354 and 356 and channel 358, and the insulating layer that includes island 360 by a sequence of PECVD steps. Insulating layer 352 can be silicon nitride deposited as described in relation to layer 254. The µc-Si layer can be deposited as described in relation to the µc-Si layer in Fig. 8, but without PH₃ so that the deposited µc-Si is undoped. The upper insulating layer that includes island 360 can be silicon nitride deposited as described in relation to the upper insulating layer that includes island 258 in Fig. 8.

The act in box 404 patterns the upper insulating layer to produce island 360. The act in box 404 can use self-aligned lithographic techniques to produce self-aligned islands by performing self-aligned backside exposure of a photoresist layer using gate 220 as a mask and by then etching to remove exposed areas of photoresist and then exposed portions of the upper insulating layer.

The act in box 410 then dopes semiconductor leads 354 and 356, such as by performing ion implantation or ion shower doping with an appropriate dopant. As a result, semiconductor leads 354 and 356 are conductive. Island 360 acts as a mask to prevent dopant particles from reaching channel 358, however, so that channel 358 remains intrinsic.

The act in box 422 patterns the source/drain metal layer, such as with a wet etchant, and then patterns the µc-Si layer, such as with a plasma etchant, to complete transistor 350. The act in box 422 can be implemented as described in relation to box 322 in Fig. 9, but without etching layers below the source/drain metal layer.

The implementations described above could be changed in many ways within the scope of the invention.

The implementations described above perform specific acts in specific sequences, but the invention could be implemented with other acts and the acts could be performed in other sequences.

The implementations described above provide thin film circuitry on an insulating substrate, such as quartz or glass. The invention could be implemented with other types of circuitry on other types of substrates.

The implementations described above provide circuitry with specific geometric and electric characteristics, but the invention could be implemented with different geometries and with different circuitry.

The implementations described above produce layers of specified thicknesses, produced from specified materials by specified processes, but other thicknesses could be produced, and other materials and processes could be used.

Specifically, the implementations described above produce layers of µc-Si with specified PECVD processes. Other low temperature processes could be used, including sputtering or evaporating silicon in a high hydrogen environment, other gases could be used in the PECVD process, such as mixtures of SiH₄ with F₂ or of SiF₄ with H₂, and other PECVD processes could be used, such as remote plasma processes. Similarly, other processes could be used to produce the amorphous silicon layers in the sensor, including sputtering and evaporation. All the silicon-based layers could be produced with PECVD, or all could be produced with sputtering, all could be produced with evaporation, or any combination of PECVD layers, sputtered layers, and evaporated layers could be produced.

Various conductive materials could be used in the layer that includes source/drain metal leads and the lower sensing element electrodes, including but not limited to any appropriate metal or alloy such as Al with or without layers or barrier metals, alloys of Al including Al-Si and alloys of Al with other metals, ITO, MoTa, Cr, MoCr, Ta, Cu, Ti, TiN, W, hybrid multilayer stacks such as TiW/AlCu, and any appropriate organic conductive materials.

Various conductive materials could also be used in the upper sensing element electrodes, with ITO being appropriate in an x-ray sensor array with a selenium coating because it provides a blocking contact that blocks injection of charge carriers into the selenium coating at high voltages; further, ITO is transparent, which may be useful in certain applications. In appropriate contexts, sensing element electrodes could be formed in Al and its alloys or a refractory metal, such as chromium, titanium, tungsten, or molybdenum, or their alloys, or even a heavily doped conductive semiconductor layer.

Also, various conductive materials could be used in the scan lines and data lines, including but not limited to any appropriate metal or alloy such as Al with or without layers or barrier metals, alloys of Al including Al-Si and alloys of Al with other metals, ITO, MoTa, Cr, MoCr, Ta, Cu, Ti, TiN, W, hybrid multilayer stacks such as TiW/AlCu, and any appropriate organic conductive materials.

Similarly, various dielectric materials could be used in the insulating layers, including but not limited to any appropriate silicon-based dielectric material, such as SiN, SiOₓN_{y}, or SiₓO_{y}, or any other dielectric material, such as TaₓO_{y} or AlₓO_{y}, or any appropriate multilayer dielectric structure.

The implementations described above produce layers in specific sequences, but the sequences of layers could be modified. Similarly, any appropriate arrangement of components in each unit of cell circuitry could be used.

The implementations described above are appropriate for an x-ray sensor array using any appropriate scintillator material. The scintillator could be thallium bromide, cesium iodide, lead iodide, or another appropriate material. In addition, the invention could be used in sensor arrays for radiation in other frequency bands detectable by a-Si based sensors. For example, the invention could be used with an a-Si photosensitive layer in a visible light sensor array as described in US-A-5,619,033.

The invention could be applied in many ways, including production of arrays for sensors of various bands of radiation, including x-rays and light in the visible or near-visible range.

A small, high resolution x-ray sensor array could be produced for mammographic imaging, while a larger, low resolution x-ray sensor array could be produced as a film replacement in other diagnostic radiology applications. X-ray sensor arrays could also be produced for luggage inspection, and other non-destructive imaging applications.

The invention has been described in relation to thin-film implementations, but the invention might be implemented with single crystal technology.

## Claims

1. A method of producing a sensor device of the type that includes a sensing element (230) and a thin film transistor (252; 350); the thin film transistor including:
a gate lead (220);
a channel (358); and
first and second channel leads (222, 224; 260, 264, 262, 266; 354, 362, 356, 364); the first channel lead (224) being electrically connected for receiving signals from the sensing element; the thin film transistor responding to signals from the gate lead by providing signals received from the sensing element to the second channel lead (222); the first and second channel leads including first and second semiconductor leads (260, 262; 354, 356), respectively;
the method comprising:
(A) producing the channel and the first and second channel leads in a first set of layers; the channel and the first and second semiconductor leads including silicon-based material; and
(B) producing the sensing element in a second set of layers over the first set of layers; the second set of layers including silicon-based material;
**characterized in that**
step (A) comprises depositing a layer of microcrystalline silicon including at least one of producing the microcrystalline silicon layer including less than five atomic percent of hydrogen and of removing native oxide from the upper side of the microcrystalline silicon layer; the layer of microcrystalline silicon including the first and second semiconductor leads.

2. The method of claim 1 in which step (B) comprises:
performing plasma enhanced chemical vapor deposition at temperatures greater than 200 DEG C to deposit a layer of amorphous silicon.

3. The method of any preceding claim in which the layer of microcrystalline silicon is a deposited doped layer.

## Patentansprüche

1. Ein Verfahren zur Herstellung einer Sensoreinrichtung von dem Typ, der ein Erfassungselement (230) und einen Dünnfilmtransistor (252; 350) einschließt, wobei der Dünnfilmtransistor einschließt:
einen Gate-Anschluss (220);
einen Kanal (358); und
erste und zweite Kanalanschlüsse (222, 224; 260, 264, 262, 266; 354, 362, 356, 364); wobei der erste Kanalanschluss (224) elektrisch verbunden ist zum Empfang von Signalen von dem Erfassungselement; der Dünnfilmtransistor auf Signale von dem Gate-Anschluss durch Bereitstellen von Signalen zu dem zweiten Kanatanschluss (222) reagiert, die von dem Erfassungselement empfangen werden; die ersten und zweiten Kanalanschlüsse erste und zweite Halbleiteranschlüsse(260, 262; 354; 356) jeweils einschließen;
wobei das Verfahren umfasst:
(A) Herstellen des Kanals und der ersten und zweiten Kanalanschlüsse in einem ersten Satz von Schichten; wobei der Kanal und die ersten und zweiten Halbleiteranschlüsse siliciumbasierendes Material einschließen; und
(B) Herstellen des Erfassungselements in einem zweiten Satz von Schichten über dem ersten Satz von Schichten; wobei der zweite Satz von Schichten siliciumbasierendes Material einschließt;
**dadurch gekennzeichnet, dass**
der Schritt (A) das Ablagern einer Schicht von mikrokristallinem Silicium umfasst, das die Herstellung der mikrokristallinen Siliciumschicht, die weniger als 5 Atomprozent von Wasserstoff einschließt und/oder das Entfernen von ursprünglichem Oxid von der oberen Seite der mikrokristallinen Siliciumschicht einschließt; wobei die Schicht aus mikrokristallinem Silicium die ersten und zweiten Halbleiteranschlüsse einschließt.

2. Das Verfahren gemäß Anspruch 1, in dem der Schritt (B) umfasst
Durchführen einer plasmaverbesserten, chemischen Dampfablagerung bei Temperaturen größer als 200 °C, um eine Schicht aus amorphem Silicium abzulagern.

3. Das Verfahren gemäß einem der vorstehenden Ansprüche, in dem die Schicht aus mikrokristallinem Silicium eine abgeschiedene, dotierte Schicht ist.

## Revendications

1. Procédé de production d'un dispositif capteur du type qui inclut un élément de détection (230) et un transistor à film mince (252 ; 350) ; le transistor à film mince incluant :
un conducteur grille (220) ;
un canal (358) ; et
un premier et un deuxième conducteurs de canal (222, 224; 260, 264, 262, 266; 354, 362, 356, 364) ; le premier conducteur de canal (224) étant électriquement connecté pour recevoir des signaux à partir de l'élément de détection ; le transistor à film mince répondant à des signaux depuis le conducteur grille en fournissant des signaux reçus à partir de l'élément de détection au deuxième conducteur de canal (222) ; le premier et le deuxième conducteurs de canal incluant un premier et un deuxième fils semi-conducteurs (260, 262, 354, 356), respectivement ;
le procédé comprenant :
(A) produire le canal et le premier et le deuxième conducteurs de canal dans un premier ensemble de couches ; le canal et le premier et le deuxième fils semi conducteurs incluant un matériau à base de silicium ; et
(B) produire l'élément de détection dans un deuxième ensemble de couches sur le premier ensemble de couches ; le deuxième ensemble de couches incluant un matériau à base de silicium ;
**caractérisé en ce que**
l'étape (A) comprend le fait de déposer une couche de silicium microcristallin incluant au moins l'un de produire la couche de silicium microcristallin incluant moins de cinq pourcent atomique d'hydrogène et d'enlever un oxyde natif du côté supérieur de la couche de silicium microcristallin ; la couche de silicium microcristallin incluant le premier et le deuxième fils semi-conducteurs.

2. Procédé de la revendication 1 dans lequel l'étape (B) comprend :
effectuer un dépôt chimique en phase vapeur assisté par plasma à des températures supérieures à 200 °C pour déposer une couche de silicium amorphe.

3. Procédé de l'une des revendications précédentes dans lequel la couche de silicium microcristallin est une couche dopée déposée.
